# EUROPEAN PATENT APPLICATION

(11) **EP 1 903 343 A1**
(43) Date of publication of application: **26.03.2008**
(21) Application number: 07116109.5
(22) Date of filing: 11.09.2007
(51) Int. Cl.: G01R 31/28

(54) **Handler**

(30) Priority: 20.09.2006 KR 20060091433
(71) Applicant: Mirae Corporation, 330-220 Chungcheongnam-do (KR)
(72) Inventor: Ahn, Jung-ug, Cheonan-si, Chungcheongnam-do, (KR); Kim, Sun-hwal, Chungcheongnam-do, (KR); Choi, Wan-hee, Cheonan-si, Chungcheongnam-do, (KR); Hur, Jung, Chungcheongnam-do, (KR)
(74) Representative: Meissner, Bolte & Partner

(57) **Abstract**

A handler is provided, including a chamber in which to-be-tested packaged chips contained in a test tray are connected to sockets of a test board, an exchanging unit exchanging the test trays with the chamber; a transferring unit transferring the test tray containing the to-be-tested packaged chips from the exchanging unit to the chamber, and transferring the test tray containing tested packaged chips from the chamber to the exchanging unit, a picker removing the tested packaged chips from the test tray staying in the exchanging unit and putting the to-be-tested packaged chips into the test tray staying in the exchanging unit; and an inserting unit including a pusher pushing the test tray to connect the to-be-tested packaged chips to the sockets of the test board, a pusher driving unit driving the pusher, a sensor sensing an amount of pressure applied by the pusher to the test tray; and a controller controlling the pusher driving unit to enable the pusher to apply a proper amount of pressure to the test tray.

## Description

### BACKGROUND OF THE INVENTION

### 1. Field of the Invention

The present invention relates to a handler for handling packaged chips, and more particularly to a handler for handling packaged chips, capable of inserting safely packaged chips contained in a test tray into sockets of a test board by applying a proper amount of pressure to the test tray.

### 2. Description of the Related Art

At the conclusion of a packaging process, a handler puts packaged chips through a series of environmental, electrical, and reliability tests. These tests vary in type and specifications, depending on the customer and use of the packaged devices. The tests may be performed on all of the packages in a lot or on selected samples.

The handler puts packaged chips into a test tray and supplies the test tray to a tester. The tester includes a test board with a plurality of sockets, performing an electrical test on the packaged chips. The packaged chips are inserted into the sockets of the test board for the electrical test.

The handler puts the packaged chips into a test tray, i.e. a jig and connecting the packaged chips contained in a test tray to sockets of the test board. The handler sorts the packaged chips according to test results.

The handler removes packaged chips from a user tray and put the removed packaged chips into the test tray. To do so, pickers are movably provided to the handler. The picker has a nozzle which absorbs the packaged chip by creating a vacuum.

The handler, after finishing putting the packaged chips into the test tray, connects the packaged chips to the sockets of the test board by applying an amount of pressure to the test tray containing the packaged chips.

When the test board finishing the electrical test on the packaged chips, the handler removes the packaged chips form the test tray, and sorts the packaged chips according to the test results. The packaged chips are contained into the user trays according to their grades. The handler includes the pickers which are employed in picking up and transferring the packaged chips.

A process of connecting the packaged chips to the sockets of the test board is now described.

The process is divided into two steps, a first connecting step and a second connecting step. The first connecting step is to move the test tray containing the packaged chips close to the test board. In the first connecting step, a proper amount of pressure may be applied to the test tray to move the test tray. The second connecting step is to insert the packaged chips contained in the test tray into the sockets of the test board. In the second inserting step, a proper amount of pressure may be applied to the test tray to insert the packaged chips into the sockets of the test board. The first and second connecting steps may be continuously performed one time without any stop in between.

In the first connecting step, the test tray is moved toward the test board, to connect the packaged chips into the sockets of the test board, or to position the test tray near the sockets of the test board.

However, a conventional handler hasn't any device sensing if a proper pressure is applied to the test tray in the first connecting step. When an excessive amount of pressure is applied to the test tray in the first inserting step, the packaged chips may collide with the sockets of the test board in the second inserting step, thus causing damage to the packaged chips. When an insufficient amount of pressure is applied to the test tray in the first transfer step, the packaged chips may not be completely connected into the sockets of the test board in the second connecting step.

When handling kinds of packaged chips for electrical test, the handler needs to change a proper amount of pressure applied to the test tray, depending upon a size or weight of the packaged chip contained in the test tray. However, the conventional handler applies the same amount of pressure to the test tray containing all kinds of the packaged chips. Thus, the packaged chips may be damaged, or may not be inserted into the sockets of the test board.

### SUMMARY OF THE INVENTION

Therefore, an object of the present invention is to An object of the present invention is to provide a proper amount of pressure to a test tray according to kinds of packaged chips in inserting the packaged chips into sockets of a test board.

According to an aspect of the present invention, there is provided a handler, including a chamber in which to-be-tested packaged chips contained in a test tray are connected to sockets of a test board, an exchanging unit exchanging the test trays with the chamber, a transferring unit transferring the test tray containing the to-be-tested packaged chips from the exchanging unit to the chamber, and transferring the test tray containing tested packaged chips from the chamber to the exchanging unit, a picker removing the tested packaged chips from the test tray staying in the exchanging unit and putting the to-be-tested packaged chips into the test tray staying in the exchanging unit and an connecting unit including a pusher pushing the test tray to connect the to-be-tested packaged chips to the sockets of the test board, a pusher driving unit driving the pusher, a sensor sensing an amount of pressure applied by the pusher to the test tray, and a controller controlling the pusher driving unit to enable the pusher to apply a proper amount of pressure to the test tray.

According to the present invention, the to-be-tested packaged chips, are prevented from damage, because the proper amount of pressure is applied to the test tray to insert the to-be-tested packaged chips into the sockets of the test board. The amount of pressure to be applied to the test tray may be adjusted depending upon kinds of the to-be-tested packaged chips.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a view illustrating a schematic configuration of a handler according to the present invention.;
FIG. 2 is a view illustrating a test board and an connecting unit of FIG. 1;
FIG. 3 is a view illustrating the connecting unit of FIG.2; and
FIG. 4 is a cross-sectional view illustrating that the packaged chips are in a state of being connected to sockets of a test board.

### DETAILED DESCRIPTION OF EXEMPLARY EMBODIMENTS

Reference will now be made in detail to the preferred embodiments of the present invention, examples of which are illustrated in the accompanying drawings.

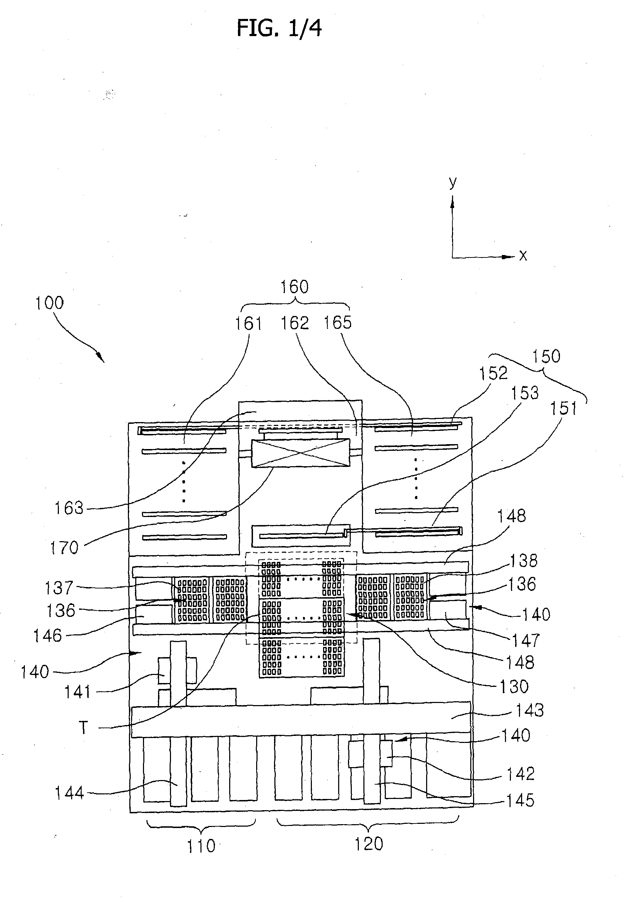

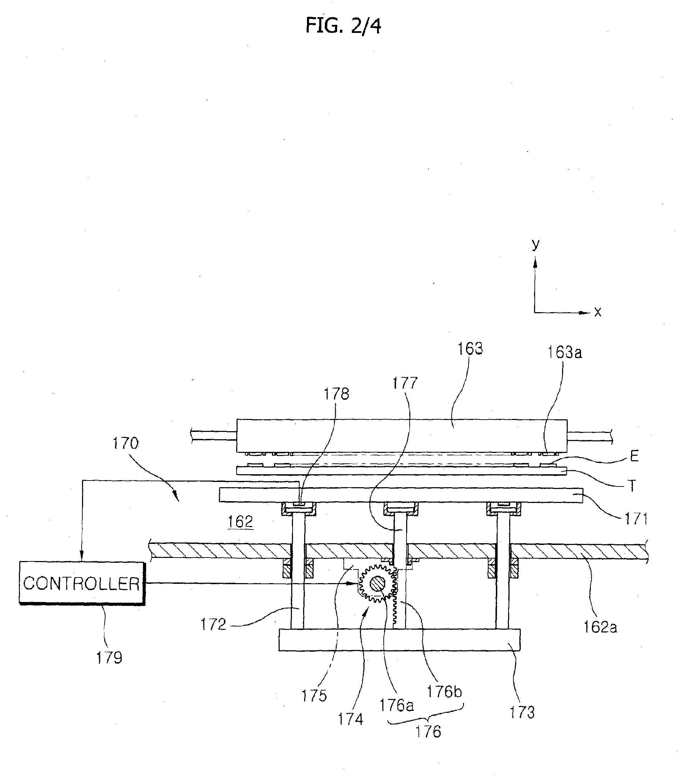

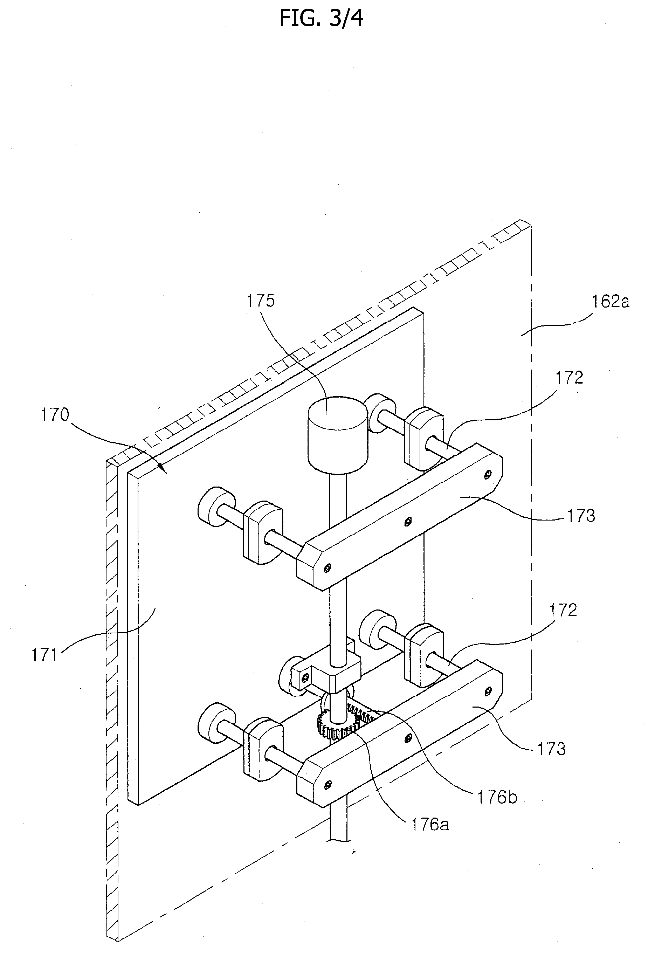

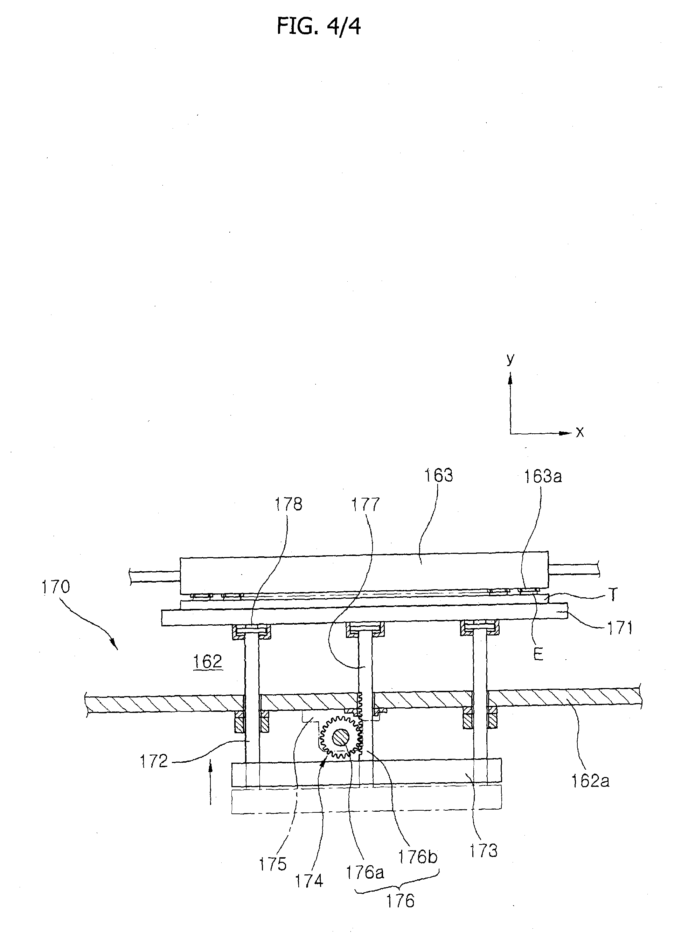

FIG. 1 is a view illustrating a schematic configuration of a handler according to the present invention. FIG. 2 is a view illustrating a test board and an connecting unit of FIG.1. FIG. 3 is a view illustrating the connecting unit of FIG.2. FIG. 4 is a cross-sectional view illustrating that the packaged chips are in a state of being connected to sockets of a test board.

Referring to FIGS. 1 and 2, the handler 100 includes a loading stacker 110, an unloading stacker 120, an exchanging unit 130, a buffer unit 136, a picker 140, a transferring unit 150, a chamber 160, and an connecting unit 170.

A plurality of user trays, each of which contains to-be-tested packaged chips, are plated on the loading stacker 110.

A plurality of user trays, each of which contains tested packaged chips, are plated on the unloading stacker 120. The tested packaged chips are sorted according to test results and contained in the user trays on the unloading stacker 102 according to their grades.

The exchanging unit 130 exchanges test trays "T" with the chamber 160.

The test tray "T" containing the to-be-tested packaged chips is transferred to the chamber 160 from the exchanging unit 130 and the test tray "T" containing the tested packaged chips is transferred to the exchanging unit 130 from the chamber 160. In this case, the transferring unit 150 may transfer the test trays between the exchanging unit 139 and the chamber 160.

In the exchanging unit 130, the to-be-tested packaged chips "E" are put into the test tray "T" and the tested packaged chips "E" are removed from the test tray "T". In this case, the picker 140 may put the to-be-tested packaged chips "E" into the test tray "T" and remove the tested packaged chips "E" from the test tray "T".

The to-be-tested packaged chips which are to be contained in the test tray "T" on the exchanging unit 130 are those which were contained in the user tray on the loading stacker 110. The tested packaged chips "E", which are to be removed from the test tray "T" on the test tray, are sorted into grades according to test results and contained in the user trays according to their grades.

Loading operation is defined as one of putting the to-be-tested packaged chips contained in the user tray on the loading stacker 110 into the test tray "T". Unloading operation is defined as one of sorting the tested packaged chips into grades according to test results and putting the tested packaged chips into the user trays on the unloading stacker 120 according to their grades.

The exchanging unit 130 may include a first exchanging unit (not shown) and a second exchanging unit (not shown). The first and second exchanging units are spaced and arranged relative to each other. In the first exchanging unit, the to-be-tested packaged chips "E" are put into the test tray "T". In the second exchanging unit, the tested packaged chips "E" are removed from the test tray "T".

The buffer unit 136 temporality receives the packaged chips "E". The buffer unit 136 includes a loading buffer unit 137 and an unloading buffer unit 138. The buffer unit 136 is provided to be movable by a linear actuator in the Y-axis direction (shown in FIG.1).

The loading buffer unit 137 temporarily receives the packaged chips "E" which are removed from the user tray. The packaged chips "E" are transferred to the exchanging unit 130 and contained in the test tray "T" in the exchanging unit 130.

The unloading buffer unit 138 temporarily receives the packaged chips "E" which are removed from the test tray "T". The packaged chips "T" are transferred to the unloading stacker 120. The packaged chips "T" are sorted into grades according to test results and contained in the user trays according to their grades.

The picker 140 performs the loading operation and the unloading operation while transferring the packaged chips. The picker 140 has a nozzle by which to absorb the packaged chips. The picker 140 includes a first picker 141, a second picker 142, a third picker 146 and a fourth picker 147.

The first picker 141 picks up the packaged chips "E" from the user tray on the loading stacker 110, transfers the packaged chips "E" ,and put the packaged chips "E" on the loading buffer unit 137.

The first picker 141 is provided to be movable in the X-axis direction and Y-axis direction from the user tray on the loading stacker to the loading buffer unit 137 and to be movable in the X-axis direction and Y-axis direction from the loading buffer unit 137 to the user tray on the loading stacker 110.

The second picker 142 picks up the packaged chips "E" from the unloading buffer unit 138, transfers the packaged chips, and puts the packaged chips into the user tray on the unloading stacker 120.

The second picker 142 is provided to be movable in the X-axis direction and the Y-axis direction from the unloading buffer unit 138 to the user tray on the unloading stacker 120 and to be movable in the X-axis direction and the Y-axis direction from the user tray on the unloading stacker 120 to the unloading buffer unit 138.

The first and second pickers 141 and 142 are provided on Y-axis frames 144 and 145, respectively, each being movable in the Y-axis direction. The Y-axis frames 144 and 145 are provided to an X-axis frame 143, respectively, each being movable in the X-axis direction. As a result, the first and second pickers 141 and 142 are movable in the X-axis and Y-axis directions.

The first picker 141, the second picker 142, and the Y-axis frames 144 and 145 may be individually driven by linear actuators.

The third picker 146 picks up the packaged chips "E" from the loading buffer unit 137, transfers the packaged chips "E", and puts the packaged chips into the test tray "T" on the exchanging unit 130.

The third picker 146 is provided to be movable in the X-axis direction both from the loading buffer unit 137 to the test tray "T" on the exchanging unit 130 and from the test tray "T" to the loading buffer unit 137.

The fourth picker 147 picks up the packaged chips from the test tray "T" on the exchanging unit 130, transfers the packaged chips, and puts the packaged chips on the unloading buffer unit 138.

The fourth picker 147 is provided to be movable in the X-axis direction both from the test tray "T" on the exchanging unit 130 to the unloading buffer unit 138 and from the unloading buffer unit 138 and to the test tray "T" on the exchanging unit 130.

The third and fourth pickers 146 and 147 are provided to the X-axis frame, each being movable in the X-axis direction. The third and fourth pickers 146 and 147 may be individually movable by linear actuators.

The transferring unit 150 transfers the test tray "T". The transferring unit 150 includes a first transferring unit 151, a second transferring unit 152, and a rotator 153.

The first transferring unit 151 transfers the test tray "T" containing the to-be-tested packaged chips from the exchanging unit 130 to the chamber 160. The first transferring unit 151 transfers the test tray "T" containing the tested packaged chips from the chamber 160 to the exchanging unit 130.

The test tray "T" containing the to-be-tested packaged chips may be transferred from the exchanging unit 130 to a first chamber 161. The test tray "T" containing the tested packaged chips may be transferred from a second chamber 165 to the exchanging unit 130.

The second transferring unit 152 transfers the test tray "T" inside of the chamber 160. The second transferring unit 152 may transfer the test tray "T" containing the to-be-tested packaged chips from the first chamber 161 to a test chamber 162 and the test tray "T" containing the tested packaged chips from the test chamber 162 to the second chamber 165.

The rotator 153 rotates the test tray "T" to allow the test tray "T" to be in a straight upright position, or to be in a horizontal position, in the exchanging unit 130. That is, the rotator 153 rotates the test tray "T" containing the to-be-tested packaged chips "E", to allow the test tray "T" to be in a straight upright position, and the test tray "T" containing the tested packaged chips "E", to allow the test tray "T" to be in a horizontal position.

In the chamber 160, the test board performs the test on the packaged chips at room temperature, and at high or low temperature. The chamber 160 includes has the first chamber 161, the second chamber 165, and the test chamber 162.

The fist chamber 161, the test chamber 162, and the second chamber 165 may be horizontally arranged adjacent to each other. A plurality of the test chambers 162 are arranged to be stacked vertically. The first chamber 161, the test chamber 162 and the second chamber are arranged to be stacked vertically.

The exchanging unit 130 the test tray "T" containing the to-be-tested packaged chips "E" are transferred to the first chamber 161. In the first chamber 161, the to-be-tested packaged chips "E" contained in the test tray are heated to temperatures (hereinafter referred to as "test temperatures") at which the test board performs the test on the to-be-tested packaged chips "E".

The test tray "T" containing the to-be-tested packaged chips "E" is transferred from the first chamber 161 to the first chamber 161. In the first chamber 161, the to-be-tested packaged chips "E" contained in the test tray are heated to temperatures (hereinafter referred to as "test temperatures") at which the test board performs the test on the to-be-tested packaged chips "E".

The first chamber 161 includes a heating unit and a cooling unit which adjust temperatures of the packaged chips "E" to the test temperatures. The heating unit may include an electric heater. The cooling unit may include a cool air injector.

When the temperatures of the packaged chips "E" are adjusted to the test temperatures, the test tray "T" is transferred by the second transferring unit 152 from the first chamber 161 to the test chamber 162.

The test board is entirely or partially inserted inside of the test chamber. The packaged chips "E" contained in the test tray "T" are connected to the sockets 163A of the test board 163 in the test chamber 162.

The test board 163 performs the electrical test on the packaged chips "E" connected to its sockets. The test board 163 may be vertically provided, so that the packaged chips may be connected to the sockets of the test board with the test try positioned vertically.

A plurality of the test chamber 162 may be provided to match a plurality of the test board 163. Thus, two or more test trays may be at the same time connected to the sockets of the test boards to increase productivity.

The chamber 162 includes a heating unit and a cooling unit which adjust temperatures of packaged chips "E" to the test temperatures. The heating unit may include an electric heater. The cooling unit may include a cool air injector.

When the test board finishes the electrical test on the packaged chips "E", the test tray "T" is transferred by the second transferring unit 152 from the test chamber 162 from the second chamber 165.

The second chamber 165 heats or cools the packaged chips "E" to room temperature. The second chamber 165 may include the heating unit and the cooling unit.

When the temperatures of the packaged chips "E" are adjusted to room temperature, the test tray "T" is transferred by the first transferring unit 151 from the second chamber 165 and the exchanging unit 130.

As shown in FIGS. 2 and 4, the inserting unit 170 safely inserts the packaged chips "E" into the sockets of the test board by applying a proper amount of pressure to the test tray "T". The connecting unit 170 includes a pusher 171, a pusher driving unit 174, a sensor 178, and a controller 179.

The pusher 171 is provided inside the test chamber 162. The pusher 171 pushes the test tray "T" staying in the test chamber 162 toward the test board 163. The pusher 171 applies the proper amount of pressure to the test tray "T" to insert the packaged chips "E" contained in the test tray "T" into the sockets 163A of the test board 163.

A size of the pusher 171 is equal to or larger than that of the test tray "T", This enables the pusher 171 to push the whole tray "T" toward the test board 163.

The pusher 171 may further include a guiding unit 171.

The guiding unit, which guides movement of the pusher 171, includes at least a pair of guide bars 172.

The guide bars 172 pierces through a shielding partition 162A. One end of the guide bars 172 are coupled to the pusher 171 inside of the shielding partition 162A and the other ends of the guide bars are coupled to a connecting member 173 outside of the shielding partition 162A. The shielding partition 162A isolates the test chamber 162 from the exchanging unit 130.

The connecting member 173, to which the ends of the guide bars are coupled, may be combined with the pusher driving unit 171. The guide bars 172, when moved by the pusher-driving unit 176, moves the pusher 171.

The pusher 171 may further include elastic projections (not shown) which protrude toward the test board 163.

The elastic projections act as a buffer which absorbs an impact when the packaged chips "E" are pushed to be inserted into the sockets 163A of the test board 163. The elastic projections spread an amount of pressure to the surface of to the test tray, thus inserting all the packaged chips into the sockets 163A of the test board 163.

The pusher 171 performs the first inserting step of moving the test tray "T" containing the packaged chips "E" close to the test board 163. Subsequently, the pusher 171 performs the second inserting step of inserting the packaged chips "E" contained in the test tray into the sockets 163A of the test board 163. The pusher 171 may separately or continuously perform the first and second steps by applying the proper amount of pressure to the test tray "T".

The pusher driving unit 174, which is coupled to the connecting member 173, is driven to move the pusher 171.

The pusher driving unit 174 may be provided outside of the shielding partition 162A. This is done to prevent particles, which occur due to movement of the pusher driving unit 162A, from influencing the electrical test of the packaged chips "E" by the test board 163.

The pusher driving unit 174 includes a motor and a converting unit 176. The pusher driving unit 174 may include whatever moves the pusher 171.

The motor 175 generates rotary motion clockwise or counterclockwise to move the pusher 171 toward or away from the test board 163. The motor 175 is provided outside of the shielding partition 162A.

The converting unit 176, which is rotated by the motor 175, converts rotary motion to linear motion, thus moving the pusher 171. The converting unit 176 may include a pinion gear 176A and a rack gear 176B.

The pinion gear 176A is coupled to the motor 175 and rotated by the motor 175.

Teeth of the rack gear 176B are engaged in those of the pinion gear 176A. Thus, rotary motion of the pinion gear 176A converts to linear motion of the rack gear 176B. The rack gear 176B is coupled to a moving block 177. The moving block 177 pierces the shielding partition 162A and connects to the pusher 171. The rack gear 176B moves the moving block 177, thereby moving the pusher 171.

The rack gear 176B connects to the connecting member 173, which connects to the guide bars 172. Linear motion of the rack gear 176B moves the connecting member 173, thereby moving the guide bars 172.

The pinion gear 176A and the rack gear 176B may be provided outside of the shielding partition 162.

The sensor 178 senses the amount of pressure which the pusher 171 applies to the test tray "T". The sensor 178 may include a load cell. The load cell is deformed according to the amount of pressure applied to the test tray "T" and electrical signals are generated according to the degree of the deformation. The electrical signals are detected to sense the amount of pressure applied to the test tray "T".

The sensor 178 may be provided on any one of the guide bar 172 and the pusher 171. That is, the sensor 178 may be provided on the contact surface between the guide bar 172 and the pusher 171. This enables the sensor 178 to sense the amount of pressure which the guide bars 172 apply to the pusher 171. The amount of pressure which the guide bars 172 apply to the pusher 171 is the same as that which the test tray "T" applies to the packaged chips "E".

Thus, the sensor 178 senses the amount of pressure which the test tray "T" applies to the packaged chips "E".

The sensor 178 may be provided on the surface of the pusher 171 which gets in contact with the test tray "T" .

The controller 179 controls the pusher-driving unit 174 to enable the pusher 171 to provide the proper amount of pressure to the test tray "T", by comparing the current amount of pressure sensed by the sensor 178 with a reference amount of pressure.

The reference amount of pressure is one by which all the packaged chips "E" contained in the test tray "T" are safely inserted into the sockets 163A of the test board 163 without having to colliding with the sockets 163A of the test board 163.

Thus, the pusher 171 is prevented from applying to the test tray "T" an excessive amount of pressure in the first connecting step, which later causes the packaged chips "E" to collide with the sockets 163A of the test board 163 in the second connecting step. Also, the pusher 171 is prevented from applying to the test tray "T" an insufficient amount of pressure in the first inserting step, which later does not enable the packaged chips "E" to get in contact with the sockets 163A of the test board 163.

The controller 179 may control the pusher driving unit 174 to enable the pusher 171 to apply a specific proper amount of pressure according to kinds of the packaged chips "E" , when the pusher 171 is required to apply a different amount of pressure depending upon the kinds of the packaged chips "E" .

It is determined if the amount of pressure applied to the test tray "T" by the pusher 171 is proper, based on the reference amount of pressure. The reference amount of pressure may be set depending upon the kinds of the packaged chips "E"

Referring to FIGS. 2 through 4, operation of the handler 100 according to the present invention is now described.

The first picker 141 picks up the packaged chips "E" from the user tray staying in the loading stacker 110, transfers the picked up packaged chips, and places the picked up packaged chips on the loading buffer unit 137.

The third 146 picks up the packaged chips "E" from the loading buffer unit 137, transfers the picked up packaged chips, and inserted the picked up packaged chips into the test tray "T".

The rotator 153 rotates the test tray "T" to allow the test tray "T" to be in a straight upright position, when the to-be-tested packaged chips are all contained in the test tray "T" staying in the exchanging unit 130. The test tray "T" rotated in a straight upright position is transferred by the first transferring unit 151 from the exchanging unit 130 to the first chamber 161.

The packaged chips "E" contained in the test tray "T" are heated or cooled in the first chamber 161. The second transferring unit 152 transfers the test tray "T" from the first chamber 161 to the test chamber 162, when the temperatures of the packaged chips "E" are adjusted to the test temperatures.

The packaged chips "E" contained in the test tray "T" are connected to the sockets 163A of the test board 163 in the test chamber 162. The test board 163 performs the electrical test on the packaged chips "E" connected to the sockets 163A of the test board 163.

The connecting unit 170 connects the packaged chips "E" contained in the test tray "T" to the sockets 163A of the test board 163.

Operation of the connecting unit 170 is now described.

The pusher 171 pushes the test tray 171, when the pusher driving unit 174 operates. Accordingly, the test tray "T" is moved toward the test board 163.

The controller 179 receives from the pusher 171 data on the amount of pressure which the pusher 171 applies to the test tray "T". The controller 179 compares the current amount of pressure applied to the test tray "T" by the pusher 171 with the reference amount of pressure.

The controller 179 stops operation of the pusher driving unit 174, when the amount of pressure which the pusher 171 applies to the test tray "T" reaches the reference amount of pressure. The first connecting step finishes when operation of the pusher driving unit 174 stops.

When the first connecting step finishes, the pusher-driving unit 174 starts to operate and initiates the second connecting step. In the second connecting step, the pusher 171 applies to the test tray "T" an amount of pressure to connect the packaged chips "E" to the sockets 163A of the test board 163. The controller 179 stops operation of the pusher-driving unit 174 when the amount of pressure which the pusher 171 applies to the test tray "T" reaches the reference amount of pressure.

The first and second connecting steps may be performed one time without any stop in between.

When the test board 163 finishes the electrical test on the packaged chips "E", the inserting unit 170 removes the amount of pressure applied to test tray "T", thus returning the test tray "T" to its original position.

When the test tray "T" comes back to its original position, the second transferring unit 152 transfers the test tray "T" from the test chamber 162 to the second chamber 165.

The second chamber 165 adjusts the temperatures of the packaged chips "E" contained in the test tray "T" to room temperature. Thereafter, the first transferring unit 151 transfers the test tray "T" from the second chamber 165 to the exchanging unit 130.

When the test tray "T' is transferred to the exchanging unit 130, the rotator 153 rotates the test tray "T" to allow the test tray "T" to be in a horizontal position.

Thereafter, the fourth picker 147 picks up the packaged chips "E" from the test tray "T" staying in the exchanging unit 130, transfers the picked up packaged chips, and places the picked up packaged chips on the unloading buffer unit 138.

The second picker 142 picks up the packaged chips "E" from the unloading buffer unit 138, transfers the picked up packaged chips "E", and inserts the picked up packaged chips "E" into the user trays according to the test results.

According to the present invention, application of the proper amount of pressure to the test tray prevents the packaged chips from colliding with the sockets of the test board and enables the packaged chips to get in safe contact with the sockets of the test board.

The proper amount of pressure applied to the test tray may be differently set depending upon kinds of the packaged chips.

The present invention provides an advantage of equipping the tray with as many carrier modules as possible because the upright-positionable packaged chip is inserted into the carrier module in the upright position, compared to a conventional carrier module into which the upright-positionable packaged chip is otherwise inserted.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalents of such metes and bounds are therefore intended to be embraced by the appended claims.

## Claims

1. A handler, comprising:
a chamber in which to-be-tested packaged chips contained in a test tray are connected to sockets of a test board;
an exchanging unit exchanging the test trays with the chamber;
a transferring unit transferring the test tray containing the to-be-tested packaged chips from the exchanging unit to the chamber, and transferring the test tray containing tested packaged chips from the chamber to the exchanging unit;
a picker removing the tested packaged chips from the test tray staying in the exchanging unit and putting the to-be-tested packaged chips into the test tray staying in the exchanging unit; and
an connecting unit comprising:
a pusher pushing the test tray to connect the to-be-tested packaged chips to the sockets of the test board;
a pusher driving unit driving the pusher, a sensor sensing an amount of pressure applied by the pusher to the test tray; and
a controller controlling the pusher driving unit to enable the pusher to apply a proper amount of pressure to the test tray.

2. The handler according to claim 1, wherein the controller controls the pusher driving unit to enable the pusher to apply the proper amount of pressure to the test tray by comparing the current amount of pressure applied to the test tray by the pusher with a reference amount of pressure.

3. The handler according to claim 1, wherein the pusher driving unit comprises a converting unit converting rotary motion of a motor into linear motion to move the pusher.

4. The handler according to claim 1, wherein the pusher driving unit comprises a converting unit comprising a pinion gear, rotated by a motor, and a rack gear which makes linear motion rotary by virtue of motion of the pinion gear to move the pusher.

5. The handler according to claim 1, wherein the sensor comprises a load cell.

6. The handler according to claim 2, wherein the reference amount of pressure is set depending upon kinds of the packaged chips.

7. The handler according to claim 1, wherein the pusher comprises a plurality of guide bars which guide movement of the pusher and the inserting unit comprises a connecting member to which the plurality of guide bars are connected and which is combined with the pusher driving unit.

8. The handler according to claim 7, wherein the sensor is provided on a surface of any one of the pusher and the guide bar, which gets in contact with a surface of the other.

9. The handler according to claim 7, wherein the pusher is provided inside of the chamber, the pusher driving unit and the connecting member are provided outside of the chamber, and the plurality of guide bars is provided to be coupled to the connecting member, piercing the chamber.

10. The handler according to claim 1, wherein the exchanging unit further comprises a rotator rotating the test tray, and the inserting unit inserts the packaged chips contained in the upright positioned test tray into the sockets of the test board.
